# DEMANDE DE BREVET EUROPEEN

(11) **EP 1 855 119 A1**
(43) Date de publication de la demande: **14.11.2007**
(21) Numéro de dépôt: 07290590.4
(22) Date de dépôt: 10.05.2007
(51) Int. Cl.: G01R 15/20

(54) **Capteur de courant, notamment pour materiel ferroviaire**

(30) Priorité: 11.05.2006 FR 0604186
(71) Demandeur: MS Relais, 93118 Rosny sous Bois (FR)
(72) Inventeur: Le Jeune, Claude, 72200 La Fleche (FR)
(74) Mandataire: Robert, Jean-Pierre

(57) **Abrégé**

Capteur de courant à cellule à effet Hall et à compensation de flux, comprenant un circuit magnétique (11) et un bobinage (12) de compensation du flux engendré par le courant à mesurer, dans lequel le circuit magnétique est de forme oblongue, les parties situées aux extrémités (11a,11b) de son grand axe étant pourvues d'un bobinage de faible épaisseur.

## Description

La présente invention concerne un capteur de courant de structure générale connue, c'est-à-dire comportant un circuit magnétique définissant entre ses deux extrémités un entrefer dans lequel est logé un détecteur sensible au champ magnétique tel qu'une cellule à effet Hall ou une magnéto-résistance. En outre, le capteur comprend un bobinage de compensation de flux qui est parcouru par un courant de compensation asservi par le détecteur pour obtenir dans l'entrefer un flux magnétique nul. C'est la valeur de ce courant de compensation qui est significative de l'intensité du courant à mesurer.

### ARRIERE PLAN DE L'INVENTION

Les spécifications géométriques d'un tel capteur, en particulier pour les engins de traction ferroviaires, en fixent de manière étroite l'encombrement extérieur qui impose des dimensions maximales pour la section du logement du conducteur traversé par le courant à mesurer. Cette section de passage est en général circulaire alors que le conducteur porteur du courant à mesurer est de section rectangulaire. Il n'est pas rare que la longueur de la section rectangulaire courante du conducteur (en amont et en aval du capteur) soit, pour une installation donnée, supérieure au diamètre de la section de passage dans le capteur. Cela oblige à prévoir, pour traverser le capteur, une pièce particulière avec une section rectangulaire de longueur plus petite mais de largeur plus importante ; en d'autres termes la plaque conductrice traversant le capteur est plus épaisse et moins large que le reste de la ligne. Cette contrainte oblige à la réalisation de connexions électriques entre la pièce rapportée et le reste de la ligne, connexions qui sont la cause des principales défaillances du montage car elles sont le siège de phénomènes corrodants qui altèrent progressivement la conductivité du montage, conduisant à des échauffements jusqu'à une mise hors service de l'appareil, sauf à procéder à des opérations de maintenance fréquentes et minutieuses. En outre, la mise en place de cette pièce particulière est consommatrice de temps, donc onéreuse.

### OBJET DE L'INVENTION

La présente invention entend remédier à cet inconvénient en proposant un capteur qui n'exige aucun conducteur d'adaptation pour sa mise en place sur une ligne habituelle, notamment dans le cas d'une application ferroviaire ce, dans le respect des spécifications étroites fixées par les utilisateurs en matière d'encombrement extérieur du capteur.

### RESUME DE L'INVENTION

A cet effet, l'invention a donc pour objet un capteur de courant à cellule à effet Hall et à compensation de flux, comprenant un circuit magnétique avec un noyau et un bobinage de compensation du flux engendré par le courant à mesurer dans lequel le noyau magnétique est de forme oblongue et les parties situées aux extrémités de son grand axe sont pourvues d'un bobinage beaucoup moins encombrant radialement que sur les autres parties du noyau.

Le circuit magnétique est formé par un noyau annulaire fendu par l'entrefer dans lequel est placée la cellule à effet Hall et par un bobinage de compensation « enveloppant » la totalité de ce noyau en augmentant sensiblement son encombrement de part et d'autre de l'axe moyen du noyau conduisant à augmenter sa dimension extérieure et à diminuer sa dimension intérieure. Il se trouve en conséquence qu'une dimension extérieure donnée, imposée par la spécification d'implantation de l'appareil, conditionne la valeur du diamètre moyen du circuit magnétique et celle du diamètre interne du bobinage. Compte tenu en plus de l'existence du boîtier enfermant le tout, on parvient au diamètre maximum de la section interne du capteur.

La distance radiale séparant les parois interne et externe d'un boîtier entourant les éléments fonctionnels du capteur définit la largeur de l'espace de logement du circuit magnétique et du bobinage de compensation qui l'entoure. En l'absence de bobinage, on constate que l'on peut radialement dilater, notamment par endroits, le circuit ferromagnétique, l'éloignant ainsi de la paroi interne du boîtier. A ces endroits, il devient possible d'augmenter la dimension radiale de la section interne du capteur en dilatant de manière semblable la paroi interne. Un conducteur plus large peut donc traverser le capteur.

La largeur du logement à ces endroits ne permet plus de contenir un bobinage de compensation conventionnel. L'expérience a montré qu'en divisant le bobinage toujours continu dans l'état de la technique le long du circuit magnétique annulaire en deux tronçons distincts, bien entendu électriquement reliés en série, les performances du capteur ne subissent aucune altération.

Ainsi a-t-on pu concevoir un capteur dit "elliptique" du fait de la forme oblongue de l'anneau magnétique, logé dans un boîtier circulaire conforme en tous points aux capteurs existants, qui est dépourvu de bobinage aux extrémités de son grand axe et qui présente une section interne élargie pour le passage d'un conducteur standard pour le domaine. Il faut entendre par dépourvu de bobinage le fait qu'aux extrémités du grand axe il peut subsister quelques spires qui assurent la continuité électrique des deux tronçons de bobinage et qui facilitent la réalisation industrielle de ces enroulements. En d'autres termes, pour diminuer l'encombrement du circuit magnétique dans des endroits spécifiques, le bobinage peut pratiquement être supprimé ou en tout cas limité à un nombre de spires qui font que son épaisseur est la plus faible, voire beaucoup plus faible que partout ailleurs le long du noyau magnétique. Ce n'est donc pas sortir du cadre de l'invention que de prévoir soit quelques spires pour assurer la continuité électrique du circuit soit plusieurs couches de spires si leur épaisseur totale est compatible avec l'espace disponible dans le boîtier.

De manière avantageuse, on préserve intégralement la forme extérieure du boîtier qui reste sensiblement de révolution pour pouvoir être accueillie dans un bâti selon plusieurs positions angulaires possibles autour de l'axe du conducteur qui traverse le capteur. D'autres caractéristiques et avantages de l'invention apparaîtront au cours de la description donnée ci-après d'un exemple de réalisation.

### BREVE DESCRIPTION DES DESSINS

Il sera fait référence aux dessins annexés dans lesquels:
- la figure 1 est une vue éclatée des composants d'un capteur conforme à l'invention,
- les figures 2 et 3 sont deux vues illustrant deux positions angulaires différentes entre un capteur selon la figure 1 et un bâti de son soutien.

### DESCRIPTION DETAILLEE DE L'INVENTION

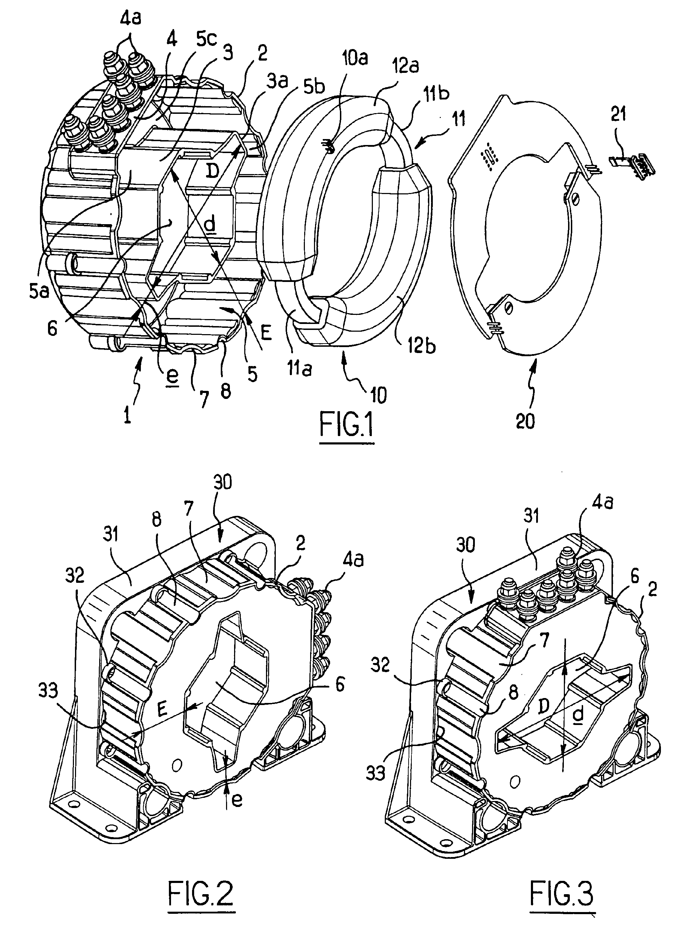

Le dispositif représenté à la figure 1 comprend trois composants: un boîtier 1, un circuit magnétique 10 et une carte de mesure 20.

Le boîtier 1 est délimité, en plus d'un fond non visible à la figure, par une paroi externe 2 de forme générale cylindrique à l'exception d'une plaque plane 4 qui porte un bornier de connexion 4a pour les entrées/sorties du capteur et une paroi interne 3 qui divise l'espace enclos par la paroi externe 2 en un espace annulaire 5 et un espace central 6, l'espace annulaire étant pourvu d'un fond 5c tandis que l'espace central est traversant. La paroi centrale 3 est généralement cylindrique dont la base est en forme d'octogone régulier (elle pourrait être circulaire) où deux cotés diamétralement opposés comportent des encoches 3a et 3b s'étendant en direction de la paroi externe 2. La dimension diamétrale de cet espace central est notée D d'un fond d'encoche à l'autre et d perpendiculairement à cette direction.

L'espace annulaire 5 est donc de largeur E entre la paroi 2 et la paroi 3 sauf au niveau des encoches où il est rétréci à une valeur e.

Le composant 10 de cette figure comporte un noyau annulaire ferromagnétique dont on ne voit que deux tronçons 11a, 11b, fendu pour définir un entrefer 10a dans lequel est logé une cellule à effet Hall 21 (ou tout autre composant électronique sensible au champ magnétique et à ses variations) qui n'est pas non plus représentée. Autour du noyau électromagnétique 11, le composant comporte un bobinage 12 en deux tronçons 12a et 12b, séparés l'un de l'autre mais électriquement reliés en série. Le noyau 11 présente donc des parties 11a et 11b dépourvues de bobinage, donc de largeur (dimension radiale) moins importante qu'au droit des tronçons de bobinage. L'ensemble affecte donc une forme oblongue aux extrémités du grand axe de laquelle se trouvent les parties équipées d'un bobinage d'épaisseur réduite. Le composant 11 peut donc être logé dans l'espace 5 dont les parties larges E accommodent les tronçons de bobinage épais et dont les parties étroites e accommodent les endroits dépourvus de bobinage épais.

Le composant 20 est un support de circuit imprimé portant des conducteurs et des éléments électroniques fonctionnels (notamment la cellule 21) pour assurer la gestion du courant de compensation et émettre en sortie un signal sur les bornes 4a significatif du courant mesuré. Ces moyens sont bien connus en eux-mêmes et ne seront pas plus décrits.

On comprend de cette illustration et de cette description que, pour un capteur de volume extérieur inchangé correspondant aux dimensions diamétrales de la paroi externe 2, le capteur de l'invention peut être traversé par un conducteur à section rectangulaire dont la largeur peut être de l'ordre de D alors qu'un capteur connu pourrait n'accueillir qu'un conducteur de largeur de l'ordre de la dimension d.

On donnera à ce propos un exemple chiffré: typiquement, un conducteur de courant pour une intensité de 2000 ampères est de section 100x10 mm. Les capteurs d'intensité pour ce calibre sont tels que leur dimension interne d est de 62 mm. Il est alors nécessaire, pour garder une valeur de section constante de présenter un conducteur avec une largeur de 60 mm pour une épaisseur de 16,6 mm. Dans le cas de l'invention, un conducteur de 100 mm de large est accepté par le capteur.

Aux figures 2 et 3, on a illustré le fait que l'invention permet de placer le capteur 1, 10, 20, assemblé (noyé dans une résine par exemple) dans un bâti 30 de support et de fixation selon plusieurs orientations angulaires relatives autour de la direction longitudinale (perpendiculaire à sa section) du conducteur parcouru par le courant à mesurer. Ceci est possible grâce au fait que la paroi externe 2 du boîtier 1 et la paroi 31 du bâti sont munies en correspondance de cannelures 7, 8 et 32, 33 de dimensions et de répartition telles qu'il est possible de placer le capteur dans le bâti 30 selon cinq positions avec un décalage angulaire de 45° entre des positions adjacentes. Des vis parallèles aux cannelures assurent la fixation du boîtier au bâti.

## Revendications

1. Capteur de courant à cellule à effet Hall et à compensation de flux, comprenant un circuit magnétique avec un noyau ferromagnétique (11a, 11b) un bobinage (12) de compensation du flux engendré par le courant à mesurer et un boîtier (1) annulaire de capotage de ces éléments fonctionnels, **caractérisé en ce que** le noyau du circuit magnétique est de forme oblongue, les parties situées aux extrémités (11a, 11b) de son grand axe étant pourvues d'un bobinage de faible épaisseur, et **en ce que** le boîtier (1) comporte une paroi extérieure (2) généralement cylindrique et une paroi intérieure (3) généralement cylindrique avec deux encoches (3a, 3b) diamétralement opposées s'étendant en direction de la paroi externe (2) à l'endroit des extrémités (11a, 11b) du circuit magnétique pourvues du bobinage de faible épaisseur.

2. Capteur de courant selon la revendication 1, **caractérisé en ce qu'**il comprend un bâti (30) de soutien et de fixation entourant la paroi extérieure (2) du boîtier annulaire (1), ce bâti (30) et cette paroi (2) comportant des moyens d'indexation (7,8 ; 32,33) angulaire de chacune de plusieurs positions relatives possibles.
